(19) Europäisches Patentamt
European Patent Office
Office européen des brevets

(11) **EP 1 852 902 A1**

(12) **EUROPEAN PATENT APPLICATION**
published in accordance with Art. 158(3) EPC

(43) Date of publication:
**07.11.2007 Bulletin 2007/45**

(21) Application number: **06713225.8**

(22) Date of filing: **07.02.2006**

(51) Int Cl.:
**H01L 21/3065** (2006.01)    **H01L 21/205** (2006.01)
**C08L 27/12** (2006.01)    **C09K 3/10** (2006.01)
**F16J 15/10** (2006.01)

(86) International application number:
**PCT/JP2006/302082**

(87) International publication number:
**WO 2006/087942 (24.08.2006 Gazette 2006/34)**

(84) Designated Contracting States:
**DE FR IE IT**

(30) Priority: **15.02.2005 JP 2005037746**

(71) Applicant: **NIPPON VALQUA INDUSTRIES, LTD.**
**Sinjuku-ku,**
**Tokyo 163-0406 (JP)**

(72) Inventor: **OKAZAKI, Masanori,**
**c/o NIPPON VALQUA IND., LTD.**
**Gojo-shi, Nara 637-0014 (JP)**

(74) Representative: **Calamita, Roberto**
**Frank B. Dehn & Co.**
**St Bride's House**
**10 Salisbury Square**
**London EC4Y 8JD (GB)**

(54) **SEAL MATERIAL FOR SEMICONDUCTOR PRODUCTION APPARATUS**

(57)    A sealing material for a semiconductor manufacturing apparatus includes as rubber components, 80 to 50 % by weight of a tetrafluoroethylene-perfluoroalkyl-vinylether type perfluoro elastomer (FFKM) and 20 to 50 % by weight of a fluoroelastomer (FKM) other than FFKM (where FFKM + FKM = 100 % by weight).

The sealing material for a semiconductor manufacturing apparatus has excellent resistance to the plasma crack and can be suitably used as a sealing material for a semiconductor manufacturing apparatus. Even when the sealing material is used in a part of the semiconductor manufacturing apparatus which is directly or indirectly irradiated with a plasma generated in the semiconductor manufacturing apparatus, it has a low rate of the weight loss and cracks are unlikely to be generated in the sealing material, and in addition, the compression set-is small and these characteristics are well balanced.

EP 1 852 902 A1

**Description**

[Technical Field]

The present invention relates to a sealing material for a semiconductor manufacturing apparatus, more specifically a fluoroelastomer type sealing material for a semiconductor manufacturing apparatus having, excellent resistance to the plasma cracking which can be suitably used as sealing material for a semiconductor manufacturing apparatus.

[Background of the Invention]

The conventional semiconductor production process includes steps using various plasmas, such as etching step and ashing step, where the plasmas of $O_2$, $CF_4$, $O_2+CF_4$, $N_2$, Ar, $H_2$, $NF_3$, $CH_3F$, $CH_2F_2$, $C_2F_6$, $Cl_2$, $BCl_3$, TEOS (Tetraethoxysilane), $SF_6$ and the like are used.

Particularly in the etching step, fluorocarbon type gas has been mainly used, and in the ashing step, a mixture of gases mainly comprising oxygen has been used.
Fluoroelastomer is frequently used as a sealing material having resistance to those plasma atmospheres. However, the fluoroelastomer has unsatisfactory resistance to the oxygen plasma in comparison with resistance to the fluorocarbon plasma, and there has been a problem of short life of the sealing material since the surface of the rubber is shaved by a plasma reaction, which causes a deformation of the sealing material, or particles are generated by the scattering of fillers blended in the rubber.

Therefore, in the oxygen plasma atmosphere, a silicone rubber which has resistance to the oxygen plasma more excellent than that of the fluorine rubber is mainly used (although unlike the fluoroelastomer, the silicone rubber has no resistance to a fluorocarbon type gas).

In the above-mentioned semiconductor production process, different semiconductor manufacturing apparatuses are frequently used depending on the kind of the plasma.
However, recently, a plurality of different products has been frequently produced using one semiconductor manufacturing apparatus, and several kinds of gases have been used in one apparatus.

However, the silicone rubber has no resistance to fluorocarbon type gases, and thus the sealing material is deteriorated quickly, so that early replacement thereof is necessary.
Therefore, as a means to solve these problems, a sealing material containing silica for a semiconductor manufacturing apparatus is proposed in Japanese Patent Laid-Open Publication No. H6-302527 (Patent Document 1). This sealing material, however, has problems that it has unsatisfactory resistance to plasma and particles are generated from silica contained as a filler.

Furthermore, as a sealing material having resistance to plasma, a rubber composition comprising a polyamine type crosslinking agent blended in a fluoroelastomer (Japanese Patent Laid-Open Publication No. 2001-114964: Patent Document 2) and a rubber composition comprising a polyamine type crosslinking agent and a polyol type vulcanization agent blended in a fluoroelastomer. (Japanese Patent Laid-Open Publication No. 2001-164066: Patent Document 3) are proposed. However, they have a problem that metal oxides used as an acid acceptor in the vulcanization can be a cause of the particle generation.

Moreover, a fluoroelastomer type composition in which a crystalline resin is added (Japanese Patent Laid-Open Publication No. 2002-161264: Patent Document 4) is proposed. However, use of this composition as a sealing material has been difficult in the semiconductor manufacturing apparatus operated under more and more severe conditions in recent years, because the composition does not have plasma resistance enough to withstand in a plasma atmosphere and the life thereof as a sealing material is short.

When a fluoroelastomer is used as a sealing material in a part of the semiconductor manufacturing apparatus which is irradiated directly or indirectly with a plasma generated in the semiconductor manufacturing apparatus, there are problems of the amount of particles generated from the sealing material and the mass loss of the sealing material. As a fluoroelastomer without the above-mentioned problems, a perfluoroelastomer is frequently used. However, a sealing material comprising a perfluoroelastomer tends to be cracked, which can frequently terminate the life thereof.

Taking into consideration the fitting properties of the sealing material and the preventing of the falling-out of the sealing material, the sealing material is frequently fitted in a little elongated state to a part to be sealed, or it is fitted in a compressed state in order to fully exhibit the sealing properties.
The sealing material which has been fitted to a predetermined position in an either elongated or compressed state tends to be cracked when exposed to a plasma irradiation atmosphere. When the generation of cracks is extreme, it is sometimes observed that the cracks cause a rupture of the sealing material.

When the crack reaches a sealing surface, a leak is generated, leading to serious troubles in the semiconductor production process such as the shutdown of the apparatus, causing a significant damage.
When the generation of cracks is predictable, the sealing material may be replaced before the generation of cracks.

However, cracks occur at various times, and thus forecasting the generation of cracks is difficult. Therefore, a demand has been increased for a sealing material having excellent resistance to plasma without the generation of cracks even when exposed in a plasma atmosphere for a long time.

In this background, the inventors of the present invention have made extensive and intensive studies. As a result, they have found that a sealing material for a semiconductor manufacturing apparatus comprising a tetrafluoroethylene-perfluoroalkylvinylether type perfluoroelastomer (FFKM) and another fluoroelastomer (FKM) in a specific amount ratio as rubber components has excellent resistance to plasma without the generation of cracks even when exposed to a plasma atmosphere for a long time. Based on the finding, the inventors have completed the present invention.

[Patent Document 1] Japanese Patent Laid-Open Publication No.H6-302527
[Patent Document 2] Japanese Patent Laid-Open Publication No.2001-114964
[Patent Document 3] Japanese Patent Laid-Open Publication No.2001-164066
[Patent Document 4] Japanese Patent Laid-Open Publication No.2002-161264

[Disclosure of the Invention]

[Problems to be solved by the Invention]

The present invention is intended to solve the above-mentioned problems associated with the related art. It is therefore an object of the present invention to provide a fluoroelastomer type sealing material for a semiconductor manufacturing apparatus which has excellent resistance to plasma and compression set and is suitably used as a sealing material for a semiconductor manufacturing apparatus.

[Means for solving the problems]

A sealing material for a semiconductor manufacturing apparatus according to the present invention comprises 80 to 50 % by weight of a tetrafluoroethylene-perfluoroalkylvinylether type perfluoroelastomer (FFKM) and 20 to 50 % by weight of a fluoroelastomer (FKM) other than FFKM as rubber components (where FFKM + FKM = 100 % by weight).

A composition for preparing a sealing material for a semiconductor manufacturing apparatus according to the present invention comprises a tetrafluoroethylene-perfluoroalkylvinylether type unvulcanized perfluoroelastomer (FFKM); an unvulcanized fluoroelastomer (FKM) other than the unvulcanized FFKM; and a crosslinking agent, wherein the unvulcanized FFKM accounts for 80 to 50 % by weight and the unvulcanized FKM accounts for 20 to 50 % by weight of 100 % by weight of the total amount of the unvulcanized FFKM and the unvulcanized FKM.

In the present invention, it is desired that both of the above-mentioned sealing material and the composition for preparing a sealing material contain substantially no filler, such as silica, carbon black, silica, clay, silicate, alumina, calcium carbonate, mica, barium sulfate or titanium oxide, because those fillers can be a cause of the particle generation when the obtained sealing material is subjected to etching by the plasma.

[Effect of the Invention]

The fluoroelastomer type sealing material for a semiconductor manufacturing apparatus according to the present invention has excellent resistance to the plasma crack and can be suitably used as a sealing material for a semiconductor manufacturing apparatus. Even when the sealing material is used in a part of the semiconductor manufacturing apparatus which is directly or indirectly irradiated with a plasma generated in the semiconductor manufacturing apparatus, it has a low rate of the weight loss (%) and cracks are unlikely to be generated in the sealing material, and in addition, the compression set (%) thereof is small and these characteristics are well balanced.

Particularly, the sealing material preferably contains substantially no filler, such as silica or carbon black, because particles are not generated even when the sealing material is subjected to etching by the plasma.

[Best Modes for Carrying Out the Invention]

Hereinafter, the sealing material used for a semiconductor manufacturing apparatus and the composition for preparing the sealing material relating to the present invention will be more specifically described.

[Sealing material for semiconductor manufacturing apparatus]

The sealing material for a semiconductor manufacturing apparatus according to the present invention comprises a tetrafluoroethylene-perfluoroalkylvinylether type perfluoroelastomer (also referred to as FFKM) and a fluoroelastomer (also referred to as FKM) other than FFKM as rubber components.

<FFKM>

The FFKM is a fluoroelastomer (copolymer) in which hydrogen atoms (H) in the side chain bonded to C-C bonds of the main chain are substantially completely replaced by fluorine atoms (F). On the other hand, the later-described FKM is a fluoroelastomer (copolymer) in which hydrogen atoms (H) in the side chain bonded to C-C bonds of the main chain are incompletely replaced by fluorine atoms, and in which hydrogen atoms (H) are partially contained.

More specifically, as described in [0024] in Japanese Patent Laid-Open Publication No. 2000-34380, the FFKM is a perfluoro type elastomer comprising 40 to 90 mol% of tetrafluoroethylene, 10 to 60 mol% of a perfluorovinylether represented by the formula: $CF_2=CF-OR_f$ (in the formula $R_f$ is a perfluoroalkyl group having 1 to 5 carbon atoms or a perfluoroalkyl (poly) ether group having 3 to 12 carbon atoms and 1 to 3 oxygen atoms) and O to 5 mol% of a monomer providing a portion to be cured, relative to 100 mol% of the total amount of all the monomers.

As the above-mentioned tetrafluoroethylene-perfluoroalkylvinylether type perfluoroelastomer (FFKM), those commercially available and publicly known can be used.
Examples of the FFKM include "Daiel Perflo G55, G65" manufactured by Daikin Industries Ltd. and "Tecnoflon PFR-94, PFR-95" manufactured by Solvay Solexis Inc.

<Fluoroelastomer other than FFKM [FKM]>

As the FKM, fluoroelastomers conventionally known other than the above-mentioned FFKM can be widely used. Examples thereof include a fluorinated vinylidene-hexafluoropropylene copolymer, a fluorinated vinylidene-hexafluoropropylene-tetrafluoroethylene copolymer (for example, "Daiel G902" manufactured by Daikin Industries Ltd.), a fluorinated vinylidene-perfluoroalkylvinylether-tetrafluoroethylene copolymer (for example, "Daiel LT302" manufactured by Daikin Industries Ltd.), an ethylene-perfluoroalkylvinylether-tetrafluoroethylene copolymer and a tetrafluoroethylene-propylene copolymer.

As the FKM, commercially available FKMs can be used, with examples including "Daiel series" manufactured by Daikin Industries Ltd., "Viton series" manufactured by DuPont Dow Elastomers L.L.C, "Tecnoflon series" manufactured by Solvay Selexis Inc., "Dyneon fluoroelastomer" manufactured by Sumitomo 3M Ltd. and "Fluon AFLAS series" manufactured by Asahi Glass Co., Ltd.

It is desired that the sealing material for a semiconductor manufacturing apparatus comprises the above-mentioned FFKM in an amount of preferably.80 to 50 % by weight and the above-mentioned FKM in an amount of preferably 20 to 50 % by weight (where FFKM + FKM = 100 % by weight), because the sealing material has excellent resistance to plasma and can suppress the crack generation when used for sealing a semiconductor manufacturing apparatus.

When the amount of FFKM in the total amount (100 % by weight) of FFKM and FKM is smaller than the above-mentioned range, there is a tendency that in a plasma environment, the rate of the weight loss of the sealing material increases and many cracks are generated in a short time. On the other hand, when the amount of FFKM is larger than the above-mentioned range, there is a tendency that the rate of the weight loss is small, but, cracks are generated to some extent in a relatively short time. When the amount of FKM is smaller than the above-mentioned range, there is a tendency that the rate of the weight loss is small, but, cracks are generated to some extent. On the other hand, when the amount of FKM is larger than the above-mentioned range, there is a tendency that in a plasma environment, the rate of the weight loss of the sealing material increases (for example, 1 % or more) and a large number of cracks is generated in a short time.

[Composition for preparing sealing material used in semiconductor manufacturing apparatus]

It is desired that the composition for preparing the sealing material of the present invention used in a semiconductor manufacturing apparatus comprises a tetrafluoroethylene-perfluoroalkylvinylether type unvulcanized perfluoroelastomer (FFKM); an unvulcanized fluoroelastomer (FKM) other than FFKM; and a crosslinking agent, wherein in the total amount of the unvulcanized FFKM and the unvulcanized FKM being 100 % by weight, the unvulcanized FFKM is contained in an amount of preferably 80 to 50 % by weight and the unvulcanized FKM other than FFKM is contained in an amount of preferably 20 to 50 % by weight, for the same reason as that in the case of the above-mentioned sealing material.

Moreover, the composition may optionally comprise a co-cross-linking agent and a filler, as well as a plasticizer, an anti-aging agent and other additive components.

<Crosslinking agent>

In general, as a crosslinking method of the fluoroelastomer (FKM), a peroxide vulcanization, a polyol crosslinking and a polyamine crosslinking are used. As a crosslinking method of the perfluoroelastomer, vulcanization methods, such as a triazine type vulcanization, a benzolate vulcanization and a peroxide vulcanization are known. As a common vulcanization method for the above-mentioned perfluoroelastomer (FFKM) and fluoroelastomer (FKM), using a peroxide crosslinking agent is preferred for progressing a substantial crosslinking.

As a crosslinking agent which can be used for a peroxide vulcanization, those conventionally known in the background art can be widely used. Specific examples thereof include a mixture of 2,5-dimethyl-2,5-(t-butyl peroxy) hexane (40%) and silica (60%) (Perhexa 25B-40, manufactured by NOF Corporation), 2,5-dimethyl-2,5-(t-butylperoxy) hexane (Perhexa 25B, manufactured by NOF Corporation), dicumyl peroxide (Percumyl D, manufactured by NOF Corporation), 2,4-dichlorobenzoyl-peroxide, di-t-butyl peroxide, t-butyl dicumyl peroxide, benzoyl peroxide (Nyper B, manufactured by NOF Corporation), 2,5-dimethyl-2,5-(t-butylperoxy)hexyne-3 (Perhexyne 25B, manufactured by NOF Corporation), 2,5-dimethyl-2,5-di(benzoylperoxy)hexane, $\alpha,\alpha$-bis(t-butylperoxy-m-isopropyl)benzene (Perbutyl P, manufactured by NOF Corporation), t-butylperoxyisopropyl carbonate, p-chlorobenzoyl peroxide, t-butylperbenzoate and the like.

Among these peroxide type crosslinking agents, 2,5-dimethyl-2,5-(t-butylperoxy)hexane is preferred from the viewpoint of physical properties and reactivity. These crosslinking agents can be used individually or in combination of two or more.

<Co-crosslinking agent>

Specific examples of the co-crosslinking agent (auxiliary agent for vulcanization) include compounds which can generate radicals for crosslinking, such,as triallyl isocyanurate (TAIC, manufactured by Nippon Kasei Chemical Co., Ltd.), triallyl cyanurate, triallyl formal , triallyl trimellitate, N,N'-m-phenylene bis-maleimide, dipropargyl terephthalate, diallyl phthalate, tetraallyl terephthalamide and the like.

Among them, triallyl isocyanurate is preferred from the viewpoint of heat resistance and reactivity.

<Filler>

Specific examples of the filler (or reinforcing agent) include carbon black (thermax N-990, manufactured by Cancarb Ltd.), silica, clay, silicate, alumina, aluminum hydroxide, calcium carbonate, silicic acid, mica, barium sulfate, titanium oxide and the like.

By using these fillers as necessary, the obtainable rubber sealing material shows preferable physical properties as a rubber sealing material (such as tensile strength, compression set, elongation and hardness). However, in an application of the rubber sealing material to the semiconductor manufacturing, when the rubber sealing material is subjected to etching by the plasma, there is a possibility of scattering of fillers contained in the rubber sealing material as particles, which may harm the production efficiency of the semiconductor. Therefore, a sealing material in which the amount of the filler is reduced as small as possible or a filler-free sealing material containing substantially no filler is frequently desired as a sealing material for a semiconductor manufacturing apparatus. Namely, in the present invention, it is desired that both of the above-mentioned sealing material and the composition for preparing the sealing material contain substantially no filler, such as silica, carbon black, silica, clay, silicate, alumina, calcium carbonate, mica, barium sulfate and titanium oxide from the viewpoint of preventing the particle generation when the sealing material is subjected to etching by the plasma.

[Production method of sealing material and composition for preparing sealing material used in semiconductor manufacturing apparatus]

The above-mentioned rubber composition and sealing material of the present invention can be manufactured by a conventionally-known method.

More specifically, for example, after the mastication of the rubber components by a kneading apparatus, such as an open roll, a Banbury mixer, a biaxial roll or the like, a blend component such as the crosslinking agent is blended to the rubber components to produce a rubber compound (the composition for preparing the sealing material used in a semiconductor manufacturing apparatus). Then, the rubber compound is filled in a metal mold having a predetermined shape and subjected to a thermal press molding, to thereby obtain a predetermined rubber molded article, such as a sealing material. Preferably, the rubber molded article is subjected to the secondary vulcanization in an oven for a predetermined time. More preferably, it is desired to conduct the secondary vulcanization under a vacuum for reducing the gas emission and the particle generation which are problems in the semiconductor production.

[Examples]

Hereinafter, the sealing material and composition for preparing the sealing material used in a semiconductor manufacturing apparatus according to the present invention will be more specifically explained referring to Examples. However, the present invention is not limited at all by these Examples.

As is apparent by the comparison of the following Examples with Comparative Examples, the sealing material of the present invention has improved resistance to plasma in a semiconductor production process and particularly reduced generation of the crack produced by the plasma which has been a problem (resistance to plasma crack), and thus has an excellent advantage as various rubber members including a sealing material for a semiconductor manufacturing apparatus which is used in plasma treatment steps used frequently in the semiconductor production, such as a plasma etching, a plasma ashing and a CVD.

<(1) Molding method of samples>

Each of rubber compounds (compositions for preparing the sealing material used in a semiconductor manufacturing apparatus) obtained by kneading each of the compositions having each of the formulations shown in Table 1 using an open-roll mill was press molded by a vacuum compression press under a pressure of 5 MPa and at 160°C for 10 min and was subjected to a secondary vulcanization using a vacuum electric furnace (degree of vacuum: 50 Pa) at 200°C for 16 hours, to thereby obtain an 0-ring molded article (sealing material) as a sample, as shown in Table 1.

(Size of 0-ring)

AS 214, inner diameter: 24.99 mm, wire diameter: 3.53 mm

<(2) Measuring method for evaluation items>

(2-1) Resistance to plasma 1 (rate of weight loss)

Using 300φ parallel flat plate plasma treater (manufactured by Hirano Kouon Co., Ltd.), a plasma was applied to the sample placed on an electrode connected to the earth under the conditions of RF of 500W, a gas flow ratio of $O_2$: $CF_4$= 9:1, a total gas flow rate of 150 sccm, a degree of vacuum of 0.5 torr and an irradiation time of 1.5 hours. The weights of the sample before and after the plasma irradiation were measured to obtain the rate of the weight loss.

(2-2) Resistance to plasma 2 (resistance to crack)

Using 300φ parallel flat plate plasma treater (manufactured by Hirano Kouon Co., Ltd.), a plasma was applied to the sample placed on an electrode connected to the earth under the conditions of RF of 500W, a gas flow ratio of $O_2$: $CF_4$= 9:1, a total gas flow rate of 150 sccm, a degree of vacuum of 0.5 torr and an irradiation time of 1.5 hours. The weights of the sample before and after the plasma irradiation were measured, and the presence or absence of a crack was checked.

An AS214 0-ring was used as the sample and it was fitted to a column so that the elongation of the inner diameter of the sample became 10%, followed by applying a plasma thereto. The crack generation was inspected every 10 minutes until approximately 1.5 hours after the start of the test. Also, the number of cracks generated was measured after 1.5 hours of the test.

(2-3) Compression set

There are some measuring items for evaluating the physical properties as a rubber sealing material. Among them, it can be mentioned that the compression set is the most important evaluation item. Therefore, the compression set was measured as a guide for evaluating whether each sample had necessary physical properties as a sealing material used in a semiconductor manufacturing apparatus or not.

The compression set (%) was calculated from the following equation according to JIS K 6262. The sample was strained as follows: the sample (AS 214 O-ring) was clamped between steel plates at a compressibility ratio of about 25% (thickness of spacer was 2.65) and heated by an electric furnace at 200°C for 70 hours, followed by natural cooling for 30 minutes.

$$\text{Compression set (\%)} = \{(T0 - T1)/(T0 - T2)\} \times 100\%,$$

T0 = height of O-ring before the test

T1 = height of 0-ring after 30 minutes after the ring was removed from the compression plates

T2 = thickness of the spacer

Components used in the following Examples and Comparative Examples are as follows:

(a) FFKM polymer: Tecnoflon PFR94 (manufactured by Solvay Solexis Inc., monomer units for binary copolymer: tetrafluoroethylene/perfluoroalkyl vinylether copolymer, Mooney viscosity (ML1 + 10, 121°C): 35, specific gravity: 2.017) .

(b) FKM polymer-1: Daiel G902 (manufactured by Daikin Industries, Ltd., monomer units for ternary copolymer: tetrafluoroethylene/hexafluoropropylene/vinylidene fluoride copolymer, Mooney viscosity (ML1 + 10, 100°C): 50, specific gravity: 1.90, fluorine content: 71 % by weight)..

(c) FKM polymer-2: Daiel LT302 (manufactured by Daikin Industries, Ltd., monomer units for ternary copolymer: tetrafluoroethylene/perfluoroalkylvinylether/vinylidene fluoride copolymer, Mooney viscosity (ML1+10, 100°C): 80, specific gravity: 1.79, fluorine content: 62 % by weight).

(d) triallyl isocyanurate: TAIC (manufactured by Nippon Kasei Chemical Co., Ltd.).

(e) mixture of 2,5-dimethyl-2,5-(t-butylperoxy)hexane (40%) _ and silica (60%): Perhexa 25B-40 (manufactured by NOF Corporation).

(f) Carbon black: thermax N-990 (manufactured by Cancarb Ltd.).

Table 1

| Formulation of composition for preparing sealing material (parts by weight) | Examples | | | | | | | Comparative Examples | | | | | | | |
|---|---|---|---|---|---|---|---|---|---|---|---|---|---|---|---|
| | 1 | 2 | 3 | 4 | 5 | 6 | 7 | 1 | 2 | 3 | 4 | 5 | 6 | 7 | 8 |
| FFKM polymer (Tecnoflon PFR94; manufactured by Solvay Solexis Inc.) | 80 | 70 | 50 | 80 | 50 | 70 | 70 | 90 | 10 | 40 | 20 | 100 | 0 | 40 | 0 |
| FKM polymer-1 (Daiel G 902; manufactured by Daikin Industries Ltd.) | 20 | 30 | 50 | 0 | 0 | 30 | 0 | 10 | 90 | 60 | 80 | 0 | 100 | 0 | 0 |
| FKM polymer-2 (Daiel LT302; manufactured by Daikin Industries Ltd.) | | | | 20 | 50 | | 30 | 0 | 0 | | | 0 | 0 | 60 | 100 |
| TAIC (triallyl isocyanurate; manufactured by Nippon Kasei Chemical Co., Ltd.) | 3 | 3 | 3 | 3 | 3 | 3 | 3 | 3 | 3 | 3 | 3 | 3 | 3 | 3 | 3 |
| Perhexa 25B-40 (manufactured by NOF Corporation) | 1.5 | 1.5 | 1.5 | 1.5 | 1.5 | 1.5 | 1.5 | 1.5 | 1.5 | 1.5 | 1.5 | 1.5 | 1.5 | 1.5 | 1.5 |
| Carbon Black (Thermax N-990; manufactured by Cancarb Ltd.) | 20 | 20 | 20 | 20 | 20 | 0 | 0 | 20 | 20 | 20 | 20 | 20 | 20 | 20 | 20 |
| Total (parts by weight) | 124.5 | 124.5 | 124.5 | 124.5 | 124.5 | 104.5 | 104.5 | 124.5 | 124.5 | 124.5 | 124.5 | 124.5 | 124.5 | 124.5 | 124.5 |
| Press (°C × min) | 160°C × 10min | 160°C × 10min | 160°C × 10min | 160°C × 10min | 160°C × 10min | 160°C × 10min | 160°C × 10min | 160°C × 10min | 160°C × 10min | 160°C × 10min | 160°C × 10min | 160°C × 10min | 160°C × 10min | 160°C × 10min | 160°C × 10min |
| Secondary vulcanization (in vacuum electric furnace) | 200°C × 16 hr | 200°C × 16 hr | 200°C × 16 hr | 200°C × 16 hr | 200°C × 16 hr | 200°C × 16 hr | 200°C × 16 hr | 200°C × 16 hr | 200°C × 16 hr | 200°C × 16 hr | 200°C × 16 hr | 200°C × 16 hr | 200°C × 16 hr | 200°C × 16 hr | 200°C × 16 hr |
| FFKM/FKM (blend ratio) | 80/20 | 70/30 | 50/50 | 80/20 | 50/50 | 70/30 | 70/30 | 90/10 | 10/90 | 40/60 | 20/80 | 100/0 | 0/100 | 20/80 | 0/100 |
| Resistance to plasma — Rate of weight loss (%) | 0.30 | 0.32 | 0.40 | 0.33 | 0.41 | 0.32 | 0.38 | 0.27 | 1.03 | 0.68 | 0.77 | 0.26 | 3.85 | 0.85 | 4.52 |
| Resistance to plasma — Time to crack generation | no crack | no crack | no crack | no crack | no crack | no crack | no crack | 80 min | 20 min | 90 min | 80 min | 10 min | 10 min | 90 min | 90 min |
| Resistance to plasma — Number of cracks after 1.5 hours of test | 0 | 0 | 0 | 0 | 0 | 0 | 0 | 3 | 7 | 4 | 6 | 10 or more (innumerable) | 2 | 3 | |
| Compression set (%) | 33 % | 32 % | 30 % | 30 % | 33 % | 29 % | 33 % | 32 % | 28 % | 31 % | 28 % | 28 % | 27 % | 34 % | 35 % |

## Claims

1. A sealing material for a semiconductor manufacturing apparatus comprising:

   80 to 50 % by weight of a tetrafluoroethylene-perfluorofalkylvinylether type perfluoroelastomer (FFKM); and
   20 to 50 % by weight of a fluoroelastomer (FKM) other than FFKM (where FFKM + FKM = 100 % by weight);
   as rubber components.

2. The sealing material for a semiconductor manufacturing apparatus according to Claim 1, wherein said sealing material contains substantially no filler.

3. A composition for preparing a sealing material used in a semiconductor manufacturing apparatus comprising:

> a tetrafluoroethylene-perfluoroalkylvinylether type
> unvulcanized perfluoroelastomer (FFKM);
> an unvulcanized fluoroelastomer (FKM) other than the
> unvulcanized FFKM; and
> a crosslinking agent,

wherein the unvulcanized FFKM accounts for 80 to 50 % by weight and the unvulcanized FKM accounts for 20 to 50 % by weight of 100 % by weight of the total amount of the unvulcanized FFKM and the unvulcanized FKM.

4. The composition for preparing a sealing material used in a semiconductor manufacturing apparatus according to Claim 3,
wherein said composition for preparing a sealing material contains substantially no filler.

## INTERNATIONAL SEARCH REPORT

| | International application No. |
|---|---|
| | PCT/JP2006/302082 |

A. CLASSIFICATION OF SUBJECT MATTER
*H01L21/3065*(2006.01), *H01L21/205*(2006.01), *C08L27/12*(2006.01),
*C09K3/10*(2006.01), *F16J15/10*(2006.01)

According to International Patent Classification (IPC) or to both national classification and IPC

B. FIELDS SEARCHED

Minimum documentation searched (classification system followed by classification symbols)
H01L21/3065, H01L21/205, C08L27/12-27/20, C09K3/10, F16J15/10

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho   1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2004-134665 A  (Asahi Glass Co., Ltd.), 30 April, 2004 (30.04.04), Full text & WO 2004/033580 A1 | 1-4 |
| A | JP 2001-348462 A  (Nichias Corp.), 18 December, 2001 (18.12.01), Full text (Family: none) | 1-4 |

☐ Further documents are listed in the continuation of Box C.     ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 02 May, 2006 (02.05.06) | 16 May, 2006 (16.05.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H6302527 A
- JP 2001114964 A
- JP 2001164066 A
- JP 2002161264 A
- JP 2000034380 A